# EUROPEAN PATENT APPLICATION

(11) **EP 4 576 212 A1**
(43) Date of publication of application: **25.06.2025**
(21) Application number: 23854680.8
(22) Date of filing: 11.04.2023
(51) Int. Cl.: H01L 25/07, H01L 23/58, H01L 25/18, H02H 3/08, H02J 1/00

(54) **SEMICONDUCTOR DC BREAKER AND SEMICONDUCTOR MODULE**

(30) Priority: 15.08.2022 JP 2022129268
(71) Applicant: Minebea Power Semiconductor Device Inc., Hitachi-shi, Ibaraki, 319-1221 (JP)
(72) Inventor: KAWASE, Daisuke, Hitachi-shi, Ibaraki 319-1221 (JP); SASAKI, Koji, Hitachi-shi, Ibaraki 319-1221 (JP); MAEDA, Daisuke, Hitachi-shi, Ibaraki 319-1221 (JP); TOMIYASU, Kunihiko, Tokyo 100-8280 (JP); KUSHIMA, Takayuki, Hitachi-shi, Ibaraki 319-1221 (JP); FURUKAWA, Tomoyasu, Tokyo 100-8280 (JP)
(74) Representative: MERH-IP Matias Erny Reichl Hoffmann Patentanwälte PartG mbB
(86) International application number: PCT/JP2023/014742
(87) International publication number: WO 2024/038640

(57) **Abstract**

Provided is a semiconductor DC breaker which has redundancy so as to be able to interrupt a current even if a semiconductor switching element for cutting off a current when an abnormal current is detected has failed. This semiconductor DC breaker 1 having a semiconductor switching element 21 that interrupts a main current when an abnormal current is detected comprises: a fuse 25 connected to the semiconductor switching element 21 in series; an abnormal current detection unit 11 that detects an abnormal current; and a gate drive unit 12 that turns off the semiconductor switching element 21 when the abnormal current is detected by the abnormal current detection unit 11. The magnitude of the abnormal current at which the semiconductor switching element 21 is to be turned off is set to be smaller than magnitude of a fusing current of the fuse 25.

## Description

### Technical Field

The present invention relates to a semiconductor DC breaker and a semiconductor module.

### Background Art

Examples of a device that cuts off a current when an abnormal current is generated include a fuse, a mechanical DC breaker, and a semiconductor DC breaker.

For example, Patent Literature 1 discloses a device that is not a semiconductor DC breaker but uses a fuse, and the abstract and Fig. 1 of Patent Literature 1 disclose that "there is provided a semiconductor module capable of continuing operation even in the event of a short-circuit fault in one semiconductor switching element during operation", and that "a semiconductor module according to an embodiment includes a first external terminal, a second external terminal, a first semiconductor switching element electrically connected between the first external terminal and the second external terminal and having a first gate electrode, a second semiconductor switching element electrically connected between the first external terminal and the second external terminal in parallel with the first semiconductor switching element and having a second gate electrode, a first fuse electrically connected between the first external terminal and the first semiconductor switching element, and a second fuse electrically connected between the second external terminal and the first semiconductor switching element".

Furthermore, for example, Patent Literature 2 discloses a semiconductor DC breaker, and the abstract and Fig. 1 of Patent Literature 2 disclose that "there is provided a semiconductor breaking device more versatile than a conventional device", and that "a semiconductor breaking device (1) includes a semiconductor switch (20), a current sensor (30) that detects a value of a current flowing through the semiconductor switch (20), and a control circuit (10) that shuts off the semiconductor switch (20) on the basis of a time-limit characteristic indicating an allowable continuous energization time corresponding to the value of the current".

### Citation List

### Patent Literature

Patent Literature 1: Japanese Patent Application Publication No. 2020-47674
Patent Literature 2: Japanese Patent Application Publication No. 2022-39777

### Summary of Invention

### Technical Problem

According to Patent Literature 1, when one of the plurality of semiconductor switching elements connected in parallel as illustrated in Fig. 6 of Patent Literature 1 has a short-circuit fault, the first fuse and the second fuse connected in series on both sides of the semiconductor switching element having the short-circuit fault are simultaneously blown to interrupt a current path to the gate electrode, which allows the remaining semiconductor switching element to continue operation. However, once a fuse is blown, it cannot be reused.

Meanwhile, according to the semiconductor DC breaker as disclosed in Patent Literature 2, an abnormal current is detected and interrupted by the semiconductor switch, which allows the reuse after the interruption. Compared with a mechanical DC breaker, the semiconductor DC breaker has an advantage that high-speed interruption characteristics of a semiconductor enable quick interruption of an abnormal current so that damage to a device to be protected may be suppressed.

However, the semiconductor switching element has a problem that an accidental failure due to a cosmic ray or the like may occur.

An object of the present invention is to provide a semiconductor DC breaker having redundancy that enables interruption of a current even when a semiconductor switching element for interrupting the current when an abnormal current is detected has failed, and a semiconductor module suitable for use therein.

### Solution to Problem

A semiconductor DC breaker according to the present invention is, for example, a semiconductor DC breaker including a semiconductor switching element that interrupts a main current when an abnormal current is detected, the semiconductor DC breaker including: a fuse connected to the semiconductor switching element in series; an abnormal current detection unit that detects the abnormal current; and a gate drive unit that turns off the semiconductor switching element when the abnormal current is detected by the abnormal current detection unit, in which magnitude of the abnormal current at which the semiconductor switching element is to be turned off is set to be smaller than that of a fusing current of the fuse.

Furthermore, a semiconductor module according to the present invention is, for example, a semiconductor module including: a semiconductor switching element that includes a first main terminal and a second main terminal; a housing that incorporates the semiconductor switching element; a first external terminal connected to the first main terminal; and a second external terminal connected to the second main terminal, in which the semiconductor switching element is a bidirectional switch in which a reference potential terminal of a first switching element having the first main terminal is connected to a reference potential terminal of a second switching element having the second main terminal, the semiconductor module further including a fuse connected to the semiconductor switching element in series and incorporated in the housing.

### Advantageous Effects of Invention

According to the present invention, a semiconductor DC breaker having redundancy that enables interruption of a current even when a semiconductor switching element for interrupting the current when an abnormal current is detected has failed, and a semiconductor module suitable for use therein may be achieved.

### Brief Description of Drawings

[Fig. 1] Fig. 1 is a circuit diagram of a semiconductor DC breaker and a semiconductor module according to Example 1.
[Fig. 2] Fig. 2 is a perspective view of the semiconductor module according to Example 1.
[Fig. 3] Fig. 3 is a perspective view of the inside of the semiconductor module according to Example 1.
[Fig. 4] Fig. 4 is a top view of the inside of the semiconductor module according to Example 1.
[Fig. 5] Fig. 5 is a top view of the inside of the semiconductor module according to Example 1.
[Fig. 6] Fig. 6 is a top view of a first external terminal and a fuse of the semiconductor module according to Example 1.
[Fig. 7] Fig. 7 is a circuit diagram of a semiconductor DC breaker and a semiconductor module according to Example 2.
[Fig. 8] Fig. 8 is a perspective view of the inside of the semiconductor module according to Example 2.
[Fig. 9] Fig. 9 is a top view of the inside of the semiconductor module according to Example 2.
[Fig. 10] Fig. 10 is a circuit diagram of a semiconductor DC breaker and a semiconductor module according to Example 3.
[Fig. 11] Fig. 11 is a circuit diagram of a semiconductor DC breaker and a semiconductor module according to Example 4.

### Description of Embodiments

Hereinafter, examples of the present invention will be described with reference to the drawings. In each of the drawings and examples, the same or similar constituent elements are denoted by the same reference signs, and redundant descriptions will be omitted.

### Example 1

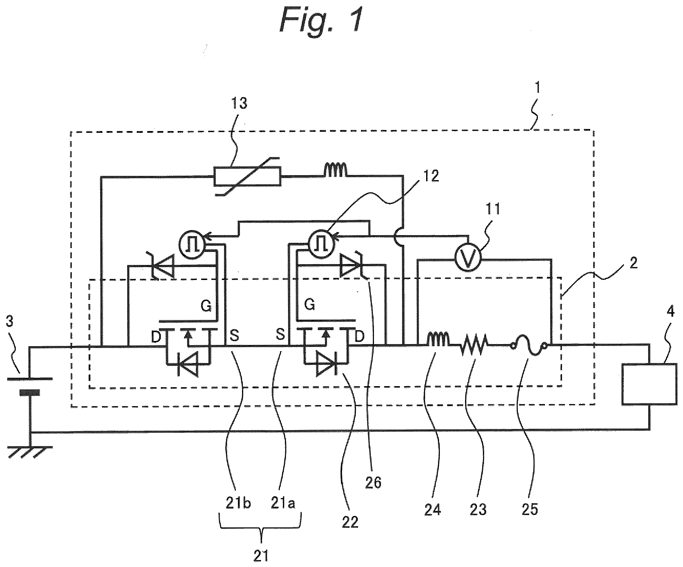

Fig. 1 is a circuit diagram of a semiconductor DC breaker and a semiconductor module according to Example 1.

A semiconductor DC breaker 1 according to Example 1 is connected between a power supply 3 and a device to be protected 4, and interrupts a current when an abnormal current is detected. Here, the semiconductor DC breaker 1 includes a semiconductor switching element 21 that interrupts a main current when an abnormal current is detected, a fuse 25 connected to the semiconductor switching element 21 in series, an abnormal current detection unit 11 that detects an abnormal current, and a gate drive unit 12 that turns off the semiconductor switching element 21 when the abnormal current detection unit 11 has detected an abnormal current. The magnitude of the abnormal current at which the semiconductor switching element 21 is to be turned off is set to be smaller than that of the fusing current of the fuse 25. Note that the fusing current of the fuse 25 is set to be equal to or smaller than the allowable current of the device to be protected 4.

With such a configuration, when an abnormal current flows, the abnormal current is detected so that the semiconductor switching element 21 may be turned off to interrupt the current before a blowout of the fuse 25, whereby the semiconductor DC breaker 1 may be reused, and even when the semiconductor switching element 21 fails due to a cosmic ray or the like, the fuse 25 connected in series melts to enable interruption of the current. In other words, there is redundancy that enables interruption of the current even when the semiconductor switching element 21 for interrupting the current when the abnormal current is detected has failed.

The semiconductor switching element 21 includes a bidirectional switch in which a reference potential terminal of a first switching element 21a is connected to a reference potential terminal of a second switching element 21b. With this arrangement, the current may be cut off in either direction. Note that a unidirectional semiconductor switching element 21 may be used if bidirectional interruption is not required.

While Fig. 1 illustrates an example of using a metal-oxide-semiconductor field-effect transistor (MOSFET) as the first switching element 21a and the second switching element 21b, it is not limited thereto, and another semiconductor switching element, such as an insulated gate bipolar transistor (IGBT), may be used.

When the semiconductor switching element 21 is a MOSFET, the reference potential terminal through which the main current flows is a source S, which is one of main terminals. In addition, a diode 22 including a body diode incorporated in the MOSFET is connected in antiparallel with a drain D, which is another main terminal through which the main current flows. Then, control signals from the gate drive unit 12 are input to a gate G to perform on/off control. Note that, in the case of the IGBT, the source may be replaced with an emitter, the drain may be replaced with a collector, and an external diode may be used as the diode 22.

The semiconductor DC breaker 1 includes a semiconductor module 2 incorporating the semiconductor switching element 21.

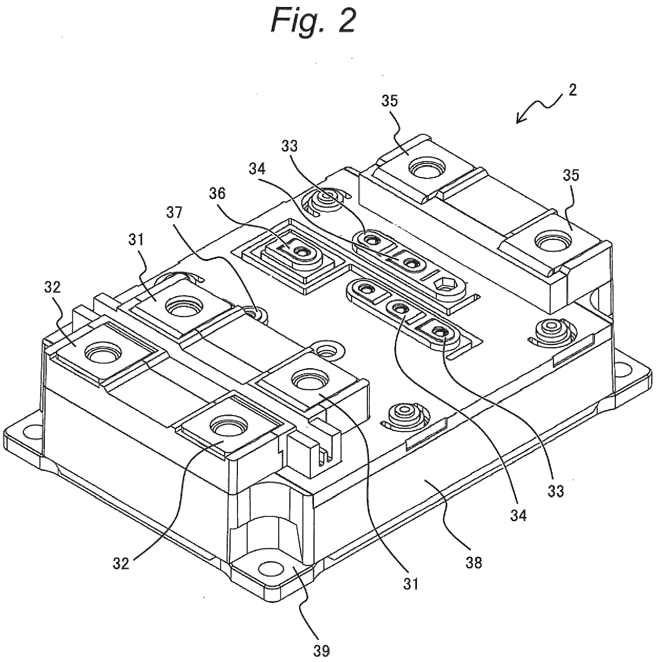

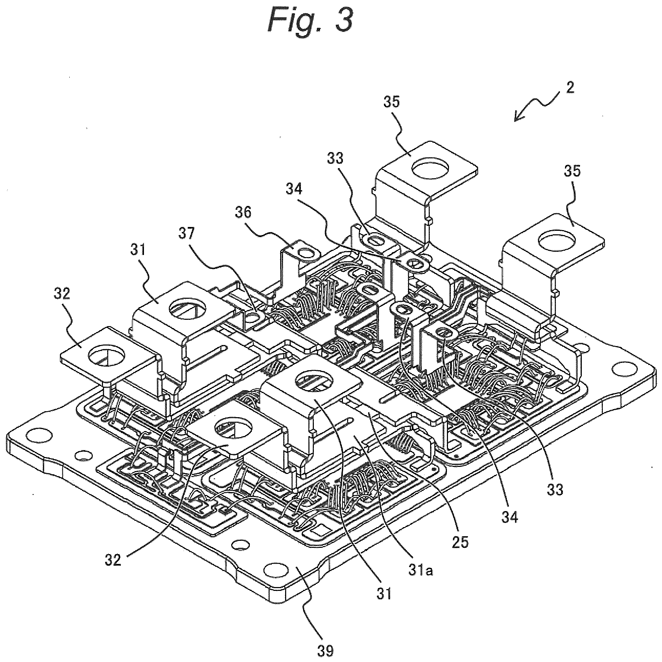

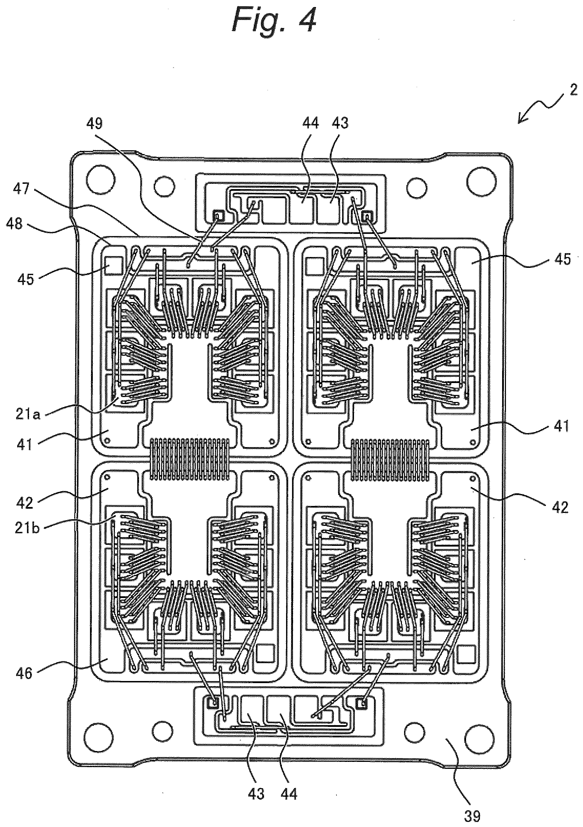

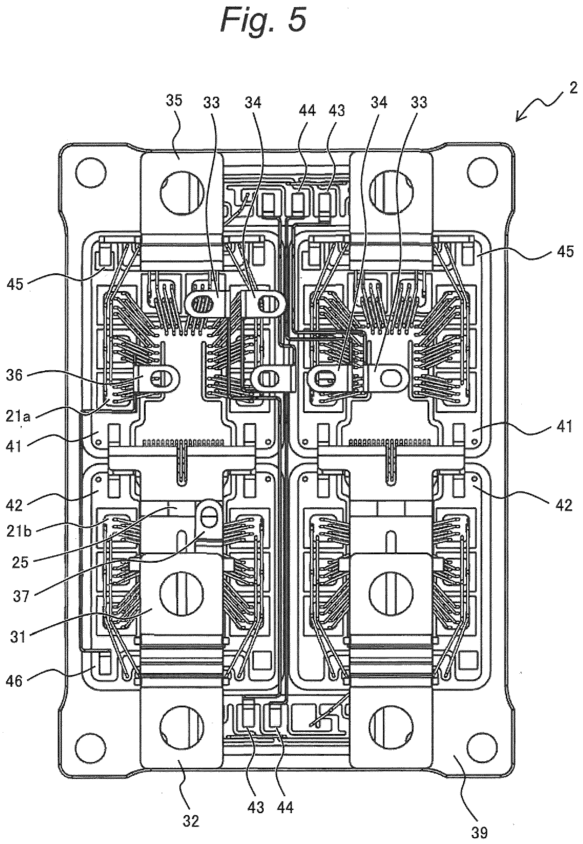

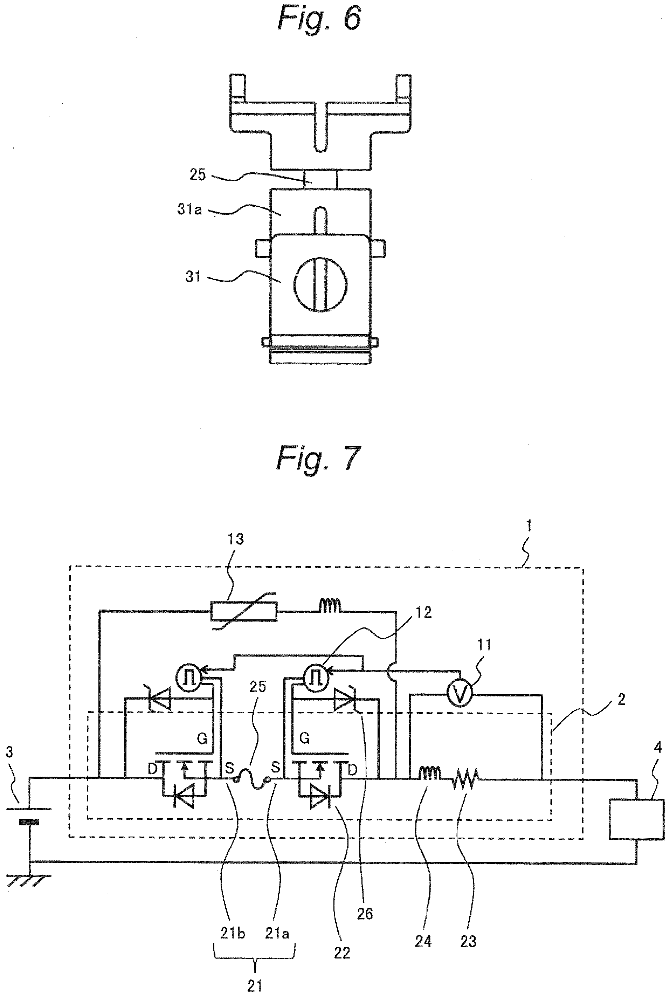

Fig. 2 is a perspective view of the semiconductor module according to Example 1, Fig. 3 is a perspective view of the inside of the semiconductor module according to Example 1, Figs. 4 and 5 are top views of the inside of the semiconductor module according to Example 1, and Fig. 6 is a top view of a first external terminal and the fuse of the semiconductor module according to Example 1. Note that, while an external terminal and an auxiliary terminal, and connection wiring integrally formed therewith are illustrated in Fig. 5, illustration of those components are omitted in Fig. 4.

The semiconductor module 2 includes the semiconductor switching element 21, a housing 38 incorporating the semiconductor switching element 21, a first external terminal 31, and a second external terminal 32. The first external terminal 31 is connected to a first main terminal of the semiconductor switching element 21, and the second external terminal 32 is connected to a second main terminal of the semiconductor switching element 21. Fig. 1 illustrates an exemplary case where the first main terminal is the drain D of the first switching element 21a, and the second main terminal is the drain D of the second switching element 21b.

Furthermore, in Example 1, the fuse 25 connected to the semiconductor switching element 21 in series is also incorporated in the housing 38 of the semiconductor module 2. In addition, the incorporated fuse 25 is formed of a part of wiring in the housing 38 in such a manner that it melts when a predetermined fusing current flows.

In Example 1, as an example of the incorporated fuse 25, the fuse 25 is formed by a part of connection wiring 31a, which is formed integrally with the first external terminal 31, being thinned as illustrated in Fig. 6. With this arrangement, as illustrated in Fig. 1, the fuse 25 may be provided between the semiconductor switching element 21 and the device to be protected 4. Note that the method of forming the fuse 25 is not limited thereto, and for example, the fuse 25 may be formed by a part of the connection wiring 31a, which is formed integrally with the first external terminal 31, being thinned in thickness, or may be made of a material having a melting point lower than that of other parts.

Furthermore, the inside of the housing 38 of the semiconductor module 2 is sealed with a gel (not illustrated), such as a silicone gel, and the fuse 25 is also sealed with the gel. With this arrangement, the dielectric withstand voltage of the fuse 25 improves, and reduction in size may be enabled.

Furthermore, the fuse 25 has a parasitic resistance and a parasitic inductance. Wiring of the semiconductor module 2 also has a parasitic resistance and a parasitic inductance. A parasitic resistance 23 illustrated in Fig. 1 includes a parasitic resistance of the wiring and a parasitic resistance of the fuse 25, and a parasitic inductance 24 includes a parasitic inductance of the wiring and a parasitic inductance of the fuse 25.

In view of the above, the abnormal current detection unit 11 according to Example 1 is configured to use the parasitic resistance or the parasitic inductance of the fuse 25 to detect an abnormal current on the basis of a voltage including a voltage generated at both ends of the parasitic resistance or the parasitic inductance of the fuse 25.

Accordingly, the semiconductor module 2 includes, as an external terminal to be connected to the outside of the housing 38, a measuring terminal capable of measuring a voltage including a voltage generated at both ends of the parasitic resistance or the parasitic inductance of the fuse 25. In Example 1, an abnormal current measurement auxiliary terminal 37 and a first drain sense auxiliary terminal 35 illustrated in Fig. 3 may be used as the measuring terminal.

The abnormal current measurement auxiliary terminal 37 is a terminal to be connected to the right side of the abnormal current detection unit 11 in Fig. 1, and is directly connected to the first external terminal 31 in Fig. 3. Note that the abnormal current measurement auxiliary terminal 37 is not limited thereto, and may be directly connected to the connection wiring 31a as long as it is closer to the first external terminal 31 than the fuse 25. Note that, while an exemplary case where the abnormal current measurement auxiliary terminal 37 is provided on only one of the two first external terminals 31 is described in Example 1, it may be provided on the other first external terminal 31, or may be provided on both first external terminals 31. Furthermore, only one first external terminal 31 may be provided.

The first drain sense auxiliary terminal 35 is a terminal to be connected to the left side of the abnormal current detection unit 11 in Fig. 1, and is connected to a first drain sense pad 45 in Fig. 5. With this arrangement, the potential of the drain D of the first switching element 21a may be measured. Note that, while the number of the first drain sense auxiliary terminals 35 provided is two in Example 1, it may be only one. In addition, the first drain sense auxiliary terminal 35 is an external terminal larger than other auxiliary terminals and having a shape close to that of the first external terminal 31. As a result, components of AC terminals of a semiconductor module used in a power converter or the like may be used. Note that the first drain sense auxiliary terminal 35 is not limited thereto, and may have a small shape similar to that of other auxiliary terminals.

As illustrated in Figs. 3 to 5, the semiconductor module 2 according to Example 1 includes six insulating substrates 47 on a base plate 39. A wiring layer 48 is formed on the insulating substrate 47, and a part thereof functions as a pad.

As illustrated in Fig. 4, a plurality of the first switching elements 21a is mounted on each of the two larger insulating substrates of the three upper insulating substrates 47, and is connected by a bonding material such as solder, a bonding wire 49, and the like. The remaining one insulating substrate is an auxiliary substrate provided with a gate pad 43 connected to the gate G of the first switching element 21a and a source sense pad 44 connected to the source sense of the first switching element 21a.

Likewise, a plurality of the second switching elements 21b is mounted on each of the two larger insulating substrates of the three lower insulating substrates 47. The remaining one insulating substrate is an auxiliary substrate provided with the gate pad 43 connected to the gate G of the second switching element 21b and the source sense pad 44 connected to the source sense of the second switching element 21b.

While it is configured such that, in order to secure current capacity, the plurality of first switching elements 21a and second switching elements 21b are used and the two insulating substrates 47 are arranged in parallel on the left side and on the right side here, the configuration is not limited thereto, and three or more insulating substrates may be arranged in parallel, or one path may be provided without being divided into left and right sides. Furthermore, the gate pads 43 and the source sense pads 44 may be provided on the insulating substrates 47 on which the first switching elements 21a and the second switching elements 21b are mounted without using the auxiliary substrate. Furthermore, the first switching elements 21a and the second switching elements 21b may be mounted on one insulating substrate 47 without being divided into upper and lower sides. That is, the number of the insulating substrates 47 is optional.

As illustrated in Figs. 3 and 5, the semiconductor module 2 includes, as external terminals, the first external terminal 31, the second external terminal 32, a gate auxiliary terminal 33, a source sense auxiliary terminal 34, the first drain sense auxiliary terminal 35, a second drain sense auxiliary terminal 36, and the abnormal current measurement auxiliary terminal 37.

The first external terminal 31 is connected to a first drain pad 41, and is connected to the drain D of the first switching element 21a so that the main current flows. The second external terminal 32 is connected to a second drain pad 42, and is connected to the drain D of the second switching element 21b so that the main current flows.

The right gate auxiliary terminal 33 is connected to the upper gate pad 43, and is connected to the gate G of the first switching element 21a. The left gate auxiliary terminal 33 is connected to the lower gate pad 43, and is connected to the gate G of the second switching element 21b.

The right source sense auxiliary terminal 34 is connected to the upper source sense pad 44, and is connected to the source sense of the first switching element 21a. The left source sense auxiliary terminal 34 is connected to the lower source sense pad 44, and is connected to the source sense of the second switching element 21b.

The gate auxiliary terminal 33 and the source sense auxiliary terminal 34 are connected to the gate drive unit 12, and the semiconductor switching element 21 is driven by control signals from the gate drive unit 12.

The first drain sense auxiliary terminal 35 and the abnormal current measurement auxiliary terminal 37 are as described above, and descriptions thereof will be omitted.

The second drain sense auxiliary terminal 36 is connected to a second drain sense pad 46. With this arrangement, the potential of the drain D of the second switching element 21b may be measured. Note that, while the number of the second drain sense auxiliary terminals 36 provided is only one in Example 1, it may be two or more.

Next, a clamp circuit according to Example 1 will be described.

As illustrated in Fig. 1, the fuse 25 is connected in series in Example 1. The fuse 25 has a large inductance because high current density needs to be set so that a blowout is caused when a predetermined fusing current flows. In a case where the inductance increases due to the series connection of the fuse 25, a surge voltage increases when the semiconductor switching element 21 is interrupted, and thus an element having a high withstand voltage is required as the semiconductor switching element 21. However, an increase in the withstand voltage of the semiconductor switching element 21 leads to an increase in the on-resistance of the semiconductor switching element 21, which involves a problem that a loss increases.

In view of the above, Example 1 adopts a configuration provided with a clamp circuit to suppress the surge voltage. with the clamp circuit including the semiconductor switching element 21 in the path and not including the fuse 25 in the path provided, the influence of the inductance of the fuse 25 may be suppressed.

In Example 1, an exemplary case where two types of clamp circuits are provided is described.

The first clamp circuit is a clamp circuit that includes a path including the first switching element 21a, a zener diode 26 connected between the gate G and the drain D of the first switching element 21a, and the gate drive unit 12. When an abnormal current is detected and the gate drive unit 12 releases charges from the gate of the first switching element 21a to interrupt the current flowing through the first switching element 21a, a drain surge voltage is induced, and when a voltage exceeding the avalanche voltage is applied to the zener diode 26, the avalanche current is charged to the gate G of the first switching element 21a, whereby the switching speed may be slowed and the current may be interrupted slowly. As a result, the maximum voltage between the source S and the drain D can be limited, which allows usage of the semiconductor switching element 21 having a low withstand voltage.

It is sufficient if the zener diode 26 to be connected to the first switching element 21a is connected between the gate auxiliary terminal 33 and the first drain sense auxiliary terminal 35 of the first switching element 21a. Note that, since the parasitic inductance is preferably smaller, a drain sense auxiliary terminal configured by a terminal smaller than the first drain sense auxiliary terminal 35 may be separately provided for the connection.

In addition, as illustrated in Fig. 1, the zener diode 26 is similarly provided between the gate G and the drain D of the second switching element 21b also on the side of the second switching element 21b, whereby a clamp circuit including the second switching element 21b in the path is provided. It is sufficient if the zener diode 26 to be connected to the second switching element 21b is connected between the gate auxiliary terminal 33 and the second drain sense auxiliary terminal 36 of the second switching element 21b. While the connection can be made with the second external terminal 32 instead of the second drain sense auxiliary terminal 36, the parasitic inductance is preferably smaller, and thus the second drain sense auxiliary terminal 36 is more preferable.

Since the fuse 25 is not included in the path of the first clamp circuit, this configuration is not affected by an increase in the inductance due to the series connection of the fuse 25.

The second clamp circuit is a clamp circuit that includes a path including the semiconductor switching element 21 and a varistor 13 connected to both ends of the semiconductor switching element 21. Note that the inductance illustrated next to the varistor 13 in Fig. 1 is a parasitic inductance of this clamp circuit. For example, a metal oxide varistor (MOV) may be used as the varistor 13. The varistor 13 avalanches and its resistance drops when a voltage at equal to or higher than a predetermined level is applied, and a current flows to the varistor 13 side as a bypass, which allows usage of the semiconductor switching element 21 having a low withstand voltage. Furthermore, since the first clamp circuit applies a thermal load to the semiconductor switching element 21 at the time of operation of the first clamp circuit, this second clamp circuit may also exert an effect of reducing the thermal load.

It is sufficient if one end of the varistor 13 is connected to the first drain sense auxiliary terminal 35 and the other end is connected to the second drain sense auxiliary terminal 36 or the second external terminal 32. Since the second external terminal 32 has a current capacity larger than that of the second drain sense auxiliary terminal 36, it is preferable to connect the other end of the varistor 13 to the second external terminal 32. Likewise, the first drain sense auxiliary terminal 35 preferably has a current capacity larger than that of other auxiliary terminals.

Since the fuse 25 is not included in the path of the second clamp circuit, this configuration is not affected by an increase in the inductance due to the series connection of the fuse 25.

Note that, while the zener diode 26 and the varistor 13 are provided outside the semiconductor module 2 in Fig. 1, at least one of them may be incorporated in the semiconductor module 2. Likewise, one or both of the abnormal current detection unit 11 and the gate drive unit 12 may be incorporated in the semiconductor module 2.

As described above, according to Example 1, the semiconductor DC breaker 1 having the redundancy that enables interruption of the current even when the semiconductor switching element 21 for interrupting the current when an abnormal current is detected has failed, and the semiconductor module 2 suitable for use therein may be achieved.

### Example 2

Example 2 is a modification example of Example 1. Example 2 is different from Example 1 in the method of implementing the fuse 25. Other than this, this example is the same as Example 1, and thus the description will focus on differences, and the overlapping description will be omitted.

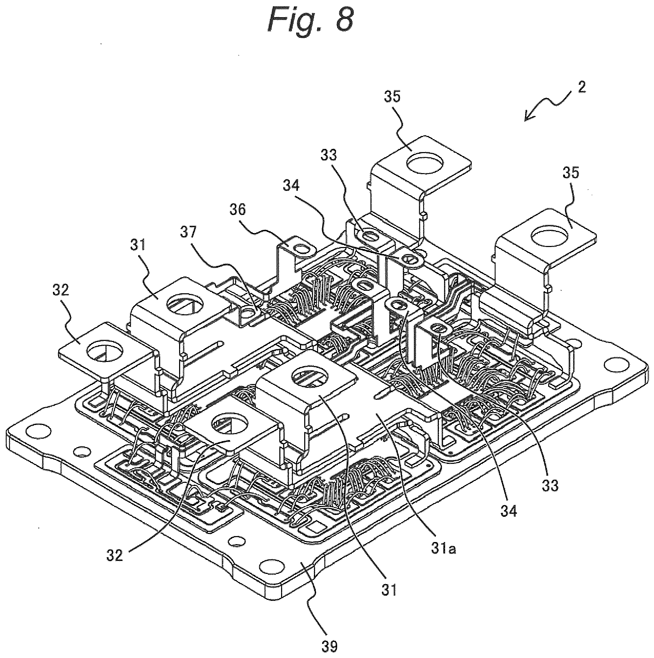

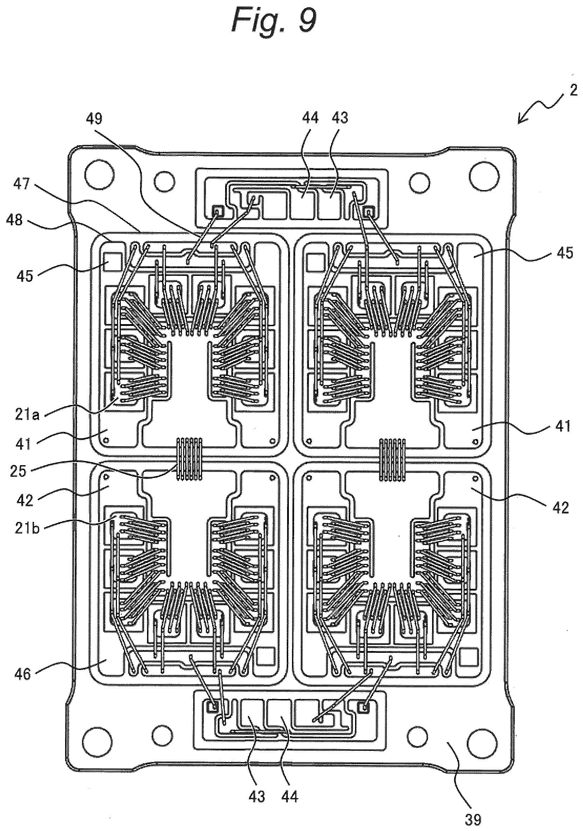

Fig. 7 is a circuit diagram of a semiconductor DC breaker and a semiconductor module according to Example 2, Fig. 8 is a perspective view of the inside of the semiconductor module according to Example 2, and Fig. 9 is a top view of the inside of the semiconductor module according to Example 2. Fig. 7 corresponds to Fig. 1, Fig. 8 corresponds to Fig. 3, and Fig. 9 corresponds to Fig. 4.

In a semiconductor DC breaker 1 and a semiconductor module 2 according to Example 2, a fuse 25 is formed between a source S that is a reference potential terminal of a first switching element 21a and a source S that is a reference potential terminal of a second switching element 21b. Note that, even in this case, the fuse 25 and a semiconductor switching element 21 are connected in series in the current path, and thus they are interpreted to be in series connection.

While Example 2 is the same as Example 1 in that the incorporated fuse 25 is formed of a part of wiring in a housing 38 in such a manner that it melts when a predetermined fusing current flows, as illustrated in Fig. 9, the number of bonding wires 49 connecting an insulating substrate 47 on which the first switching element 21a is mounted with an insulating substrate 47 on which the second switching element 21b is mounted is smaller than that in Fig. 4, thereby functioning as the fuse 25. Accordingly, there is an advantage that implementation is easier than that in Example 1. The fuse 25 according to Example 2 may also be sealed with a gel.

However, since a parasitic resistance 23 and a parasitic inductance 24 do not include the parasitic resistance and the parasitic inductance of the fuse 25 in Example 2, sensitivity for detecting an abnormal current is higher in Example 1. In addition, while this example is the same as Example 1 in that the fuse 25 is not included in the path of the first clamp circuit, which exerts the same effect, this example is different from Example 1 in that the fuse 25 is included in the path of the second clamp circuit so that the second clamp circuit is affected by an increase in the inductance due to the series connection of the fuse 25.

### Example 3

Example 3 is a modification example of Example 1. Example 3 is different from Example 1 in that the fuse 25 is provided outside the semiconductor module 2. Other than this, this example is the same as Example 1, and thus the description will focus on differences, and the overlapping description will be omitted.

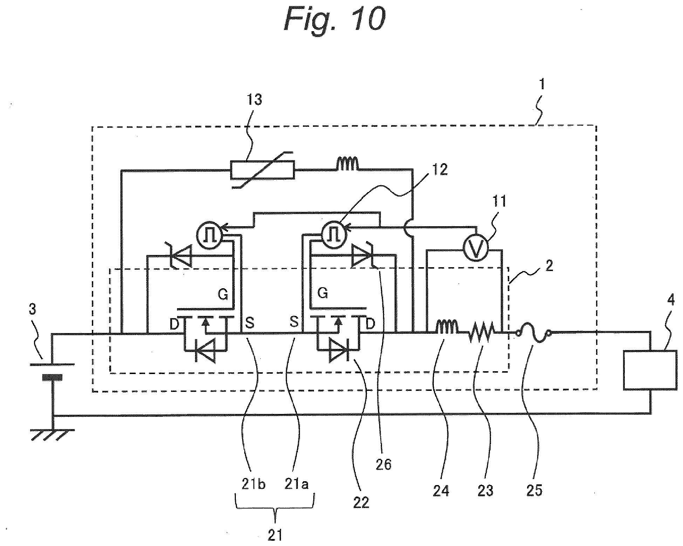

Fig. 10 is a circuit diagram of a semiconductor DC breaker and a semiconductor module according to Example 3. Fig. 10 corresponds to Fig. 1.

In a semiconductor DC breaker 1 and a semiconductor module 2 according to Example 3, a fuse 25 is provided outside the semiconductor module 2. Therefore, a common fuse may be used as the fuse 25.

### Example 4

Example 4 is a modification example of Example 3. Example 4 is different from Example 3 in the method of detection by the abnormal current detection unit 11. Other than this, this example is the same as Example 3, and thus the description will focus on differences and the overlapping description will be omitted.

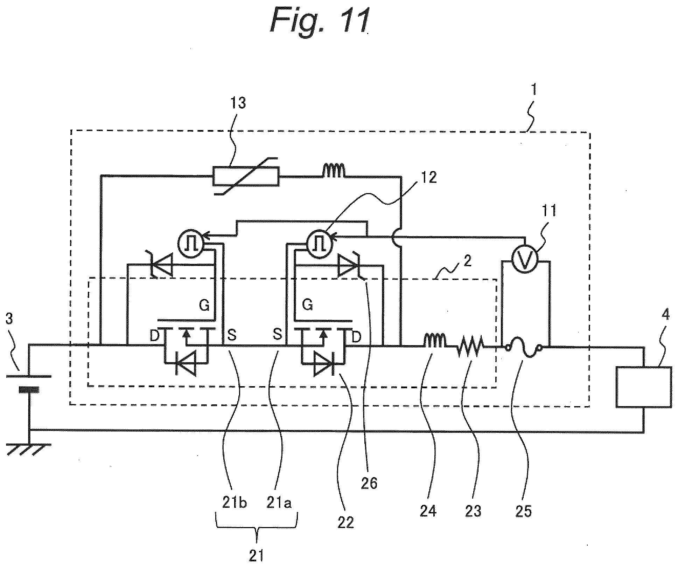

Fig. 11 is a circuit diagram of a semiconductor DC breaker and a semiconductor module according to Example 4. Fig. 11 corresponds to Fig. 10.

In a semiconductor DC breaker 1 and a semiconductor module 2 according to Example 4, a fuse 25 is provided outside the semiconductor module 2 in a similar manner to Example 3. Therefore, a common fuse may be used as the fuse 25.

In addition, the abnormal current detection unit 11 detects an abnormal current on the basis of a voltage including a voltage generated at both ends of a parasitic resistance or a parasitic inductance of the fuse 25.

While the examples of the present invention have been described above, the present invention is not limited to the configurations described in the examples, and various modifications may be made within the scope of the technical concept of the present invention. In addition, some or all of the configurations described in each example may be combined and applied.

### Reference Signs List

- 1: Semiconductor DC breaker
- 2: Semiconductor module
- 3: Power supply
- 4: Device to be protected
- 11: Abnormal current detection unit
- 12: Gate drive unit
- 13: Varistor
- 21: Semiconductor switching element
- 21a: First switching element
- 21b: Second switching element
- 22: Diode
- 23: Parasitic resistance
- 24: Parasitic inductance
- 25: Fuse
- 26: Zener diode
- 31: First external terminal
- 31a: Connection wiring
- 32: Second external terminal
- 33: Gate auxiliary terminal
- 34: Source sense auxiliary terminal
- 35: First drain sense auxiliary terminal
- 36: Second drain sense auxiliary terminal
- 37: Abnormal current measurement auxiliary terminal
- 38: Housing
- 39: Base plate
- 41: First drain pad
- 42: Second drain pad
- 43: Gate pad
- 44: Source sense pad
- 45: First drain sense pad
- 46: Second drain sense pad
- 47: Insulating substrate
- 48: Wiring layer
- 49: Bonding wire
- G: Gate
- S: Source
- D: Drain

## Claims

1. A semiconductor DC breaker that includes a semiconductor switching element that interrupts a main current when an abnormal current is detected, the semiconductor DC breaker comprising:
a fuse connected to the semiconductor switching element in series;
an abnormal current detection unit that detects the abnormal current; and
a gate drive unit that turns off the semiconductor switching element when the abnormal current is detected by the abnormal current detection unit, wherein
magnitude of the abnormal current at which the semiconductor switching element is to be turned off is set to be smaller than magnitude of a fusing current of the fuse.

2. The semiconductor DC breaker according to claim 1, wherein
the abnormal current detection unit detects the abnormal current on a basis of a voltage including a voltage generated at both ends of a parasitic resistance or a parasitic inductance of the fuse.

3. The semiconductor DC breaker according to claim 1, further comprising:
a clamp circuit that includes the semiconductor switching element in a path and does not include the fuse in the path.

4. The semiconductor DC breaker according to claim 1, wherein
the semiconductor switching element is a bidirectional switch in which a reference potential terminal of a first switching element is connected to a reference potential terminal of a second switching element.

5. The semiconductor DC breaker according to claim 1, wherein
the semiconductor switching element includes a first main terminal and a second main terminal through which the main current flows, the semiconductor DC breaker further comprising:
a semiconductor module that includes the semiconductor switching element, a housing that incorporates the semiconductor switching element, a first external terminal connected to the first main terminal, and a second external terminal connected to the second main terminal, wherein
the fuse is incorporated in the housing of the semiconductor module.

6. The semiconductor DC breaker according to claim 5, wherein
the fuse includes a part of wiring in the housing, and is blown when the fusing current flows.

7. The semiconductor DC breaker according to claim 6, wherein
the fuse is formed by a part of connection wiring formed integrally with the first external terminal being thinned or being thinned in thickness, or includes a material having a melting point lower than the melting point of another part.

8. A semiconductor module comprising:
a semiconductor switching element that includes a first main terminal and a second main terminal; a housing that incorporates the semiconductor switching element; a first external terminal connected to the first main terminal; and a second external terminal connected to the second main terminal, wherein
the semiconductor switching element is a bidirectional switch in which a reference potential terminal of a first switching element having the first main terminal is connected to a reference potential terminal of a second switching element having the second main terminal, the semiconductor module further comprising:
a fuse connected to the semiconductor switching element in series and incorporated in the housing.

9. The semiconductor module according to claim 8, wherein
the fuse includes a part of wiring in the housing, and is blown when a predetermined fusing current flows.

10. The semiconductor module according to claim 9, wherein
the fuse is formed by a part of connection wiring formed integrally with the first external terminal being thinned or being thinned in thickness, or includes a material having a melting point lower than the melting point of another part.

11. The semiconductor module according to claim 9, wherein
the fuse is provided between the reference potential terminal of the first switching element and the reference potential terminal of the second switching element.

12. The semiconductor module according to claim 8, further comprising:
a gel in the housing, wherein
the fuse is sealed with the gel.

13. The semiconductor module according to claim 8, further comprising:
a measuring terminal capable of measuring a voltage including a voltage generated at both ends of a parasitic resistance or a parasitic inductance of the fuse, as an external terminal to be connected to an outside of the housing.

14. A semiconductor DC breaker comprising:
the semiconductor module according to any one of claims 8 to 13;
an abnormal current detection unit that detects an abnormal current on a basis of a voltage including a voltage generated at both ends of a parasitic resistance or a parasitic inductance of the fuse; and
a gate drive unit that turns off the semiconductor switching element when the abnormal current is detected by the abnormal current detection unit, wherein
magnitude of the abnormal current at which the semiconductor switching element is to be turned off is set to be smaller than magnitude of a fusing current of the fuse.
